# EUROPEAN PATENT SPECIFICATION

(11) **EP 1 653 617 B1**
(45) Date of publication and mention of the grant of the patent: **18.04.2012**
(21) Application number: 05109772.3
(22) Date of filing: 20.10.2005
(51) Int. Cl.: H03K 3/0231

(54) **Relaxation oscillator and relative operation method.**
Kippschwingungs-Oszillator und Verfahren zu seinem Betrieb.
Oscillateur à relaxation et son procédé de fonctionnement.

(30) Priority: 28.10.2004 IT MI20042052
(43) Date of publication of application: 03.05.2006
(73) Proprietor: STMicroelectronics S.r.l., 20041 Agrate Brianza (MB) (IT)
(72) Inventor: CONTE, Antonino, 95030, TREMESTIERI ETNEO (CT) (IT); DI MARTINO, Alberto Josè, 96100, SIRACUSA (IT)
(74) Representative: Mittler, Enrico

(56) References cited:
- US-A- 4 623 851
- US-A- 5 283 515
- SHAKIBA M H ET AL: "AUTOMATIC SWING CONTROL IN RELAXATION OSCILLATORS" IEEE JOURNAL OF SOLID-STATE CIRCUITS, IEEE SERVICE CENTER, PISCATAWAY, NJ, US, vol. 33, no. 12, December 1998 (1998-12), pages 1979-1986, XP000880500 ISSN: 0018-9200

## Description

The present invention refers to an oscillator and the relative operation method.

A circuit topology of oscillators generally used for generating a square wave is based on the constant-current charging of one or more capacitors between two levels of voltage. The oscillating frequency of said type of oscillator is set by the time that the capacitor takes to charge from one level of voltage to the other, that is it is given by the ratio between the charging capacity of the capacitor and the charging current.

For said types of oscillators there are various methods for controlling the charging or discharging of the capacitor; amongst the most common are the method of controlling the transistor threshold voltage and the method of controlling through differential comparators.

With the first method a terminal of the capacitor is connected to the gate terminal of a MOS transistor whose task is to block the charging of the capacitor when it is on to reactivate it when it is off. Said control method is simple but is strongly dependent on the temperature and on the process variables.

With the second method the output of a differential comparator that compares the voltage on the capacitor with a reference voltage is used to activate or de-activate the charging of the capacitor. Said type of control is more complex but is more stable and its consumption increases with the frequency given that the correct functioning depends on the speed of response of the differential comparator.

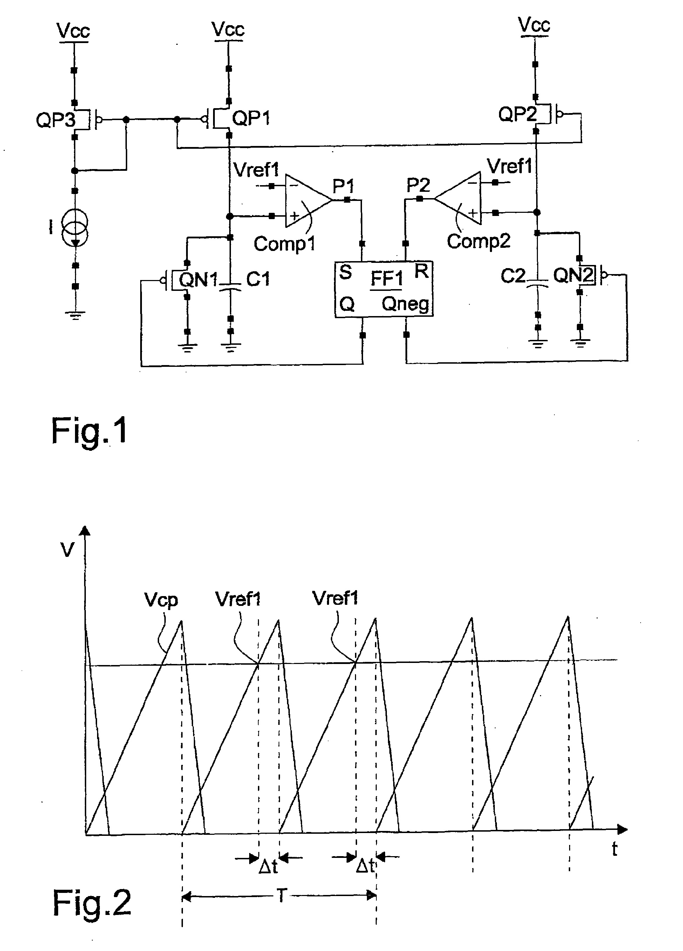

In Figure 1 a constant-charge oscillator with a control device based on differential comparators is shown. The oscillator comprises two capacitors C1 and C2 charged by a current I by means of two current mirrors QP1-QP3, QP2-QP3 connected to the supply voltage Vcc. The capacitor C1 has a terminal connected to ground and the other terminal connected to the non-inverting terminal of a differential comparator Compl having the inverting terminal connected to a reference voltage Vrefl. The capacitor C2 has a terminal connected to ground and the other terminal connected to the non-inverting terminal of a differential comparator Comp2 having the inverting terminal connected to a reference voltage Vrefl. The outputs P1 and P2 of the comparators Comp1 and Comp2 constitute the inputs set S and reset R of a set-reset flip-flop FF1 whose outputs Q and Qneg are the drive voltages of two MOS transistors QN1 and QN2 having the drain terminal connected respectively to the terminal of the capacitors C1 and C2. The voltage levels are ground and the voltage Vrefl and the halfperiod is given by the time taken by the voltage at the terminals of the capacitors C1 and C2 to go from ground to the voltage Vrefl.

The comparators COMP1 and COMP2 generate the signals needed for controlling the charging and discharging of the capacitors C1 and C2. When the outputs of the flip-flop FF1 are Q=0, Qneg=1, the transistor QN1 is off; in this way the capacitor C1 can charge itself with the current I supplied by the mirror QP1-QP3 while the transistor QN2 is on keeping the capacitor C2 discharged and the voltage on the non-inverting terminal of the comparator Comp2 at ground. The capacitor C1 will charge until the voltage on the non-inverting terminal of the comparator Comp1 reaches the voltage Vrefl making the output of COMP1 switch from 0 to 1 and setting the outputs of the flip-flop FF1 at Q=1, Qneg=0. In this way the transistor QN1 turns on rapidly discharging the capacitor C1 and the transistor QN2 turns off enabling the charging of the capacitor C2 with the current I supplied by the mirror QP2-QP3. The capacitor C2 will charge until the voltage on the non-inverting terminal of the comparator Comp1 reaches the voltage of Vrefl making the comparator COMP1 switch and bringing back the flip-flop FF1 to its starting state; in this way the charging and discharging cycle of the capacitors C1 and C2 is alternated. If the transistor QP1 and the capacitor C1 are equal respectively to the transistor QP2 and to the capacitor C2, a square wave with duty-cycle of 50% will be generated in output to the flip-flop FF1.

A heavy limitation in frequency in the use of this type of oscillator is the switching speed of the comparators COMP1 and COMP2. Figure 2 shows how the voltage Vcp evolves at the terminals of the two capacitors C1 and C2; actually the comparators do not switch when the voltage in the capacitors reaches the voltage Vrefl but a period of time Δt after for the delay of the comparator. At high frequencies, when the period of time Δt is not negligible compared to the period of period of oscillation T, the working frequency of the oscillator cannot be set only by the current-capacity ratio in the capacitors but must be considered a variable Δt with the working conditions. In addition, in high frequency, a high speed of charging or discharging enables the transformation of the period of time Δt into a high variation of voltage ΔV, compromising the functioning of the oscillator at low supply voltages.

The article of SHAKIBA M H ET AL: "Automatic swing control in relaxation oscillators" IEEE JOURNAL OF SOLID STATE CIRCUITS, IEEE SERVICE CENTER, PISCATAWAY, NJ, US, vol. 33, no. 12, December 1998, pages 1979-1986, XP000880500, ISSN: 0018-9200, discloses an oscillator similar to one of the four oscillators as defined in claim 1.

In view of the state of the technique described, object of the present invention is to provide an oscillator that overcomes the above mentioned inconveniences.

In accordance with the present invention, this object is achieved by means of an oscillator as defined in claim 1.

Still in accordance with the present invention it is possible to provide an operation method of the oscillator as defmed in claim 4.

Thanks to the present invention it is possible to produce an oscillator that guarantees the achievement of higher operation frequencies and the use of a lower supply voltage. In addition said oscillator is more stable compared to the temperature variations, to the variations of the supply voltage and presents greater stability in respect of the process variables. Said oscillator also presents lower consumption compared to known oscillators.

The characteristics and advantages of the present invention will appear evident from the following detailed description of an embodiment thereof illustrated as non-limiting example in the enclosed drawings, in which:
Figure 1 is a circuit diagram of an oscillator according to the known art;
Figure 2 is a graph of the time trend of the voltage in the capacitors of the circuit of Figure 1;
Figure 3 is a block diagram of the oscillator according to the present invention;
Figure 4 is a diagram of a circuit implementation of the oscillator of Figure 3;
Figure 5 shows a graph of the signals in output from several elements of the circuit of Figure 4;
Figure 6 is a circuit diagram of an element of the circuit of Figure 4;
Figure 7 is a circuit diagram of an element for the generation of a bias voltage needed by circuit of Figure 3;
Figure 8 is a circuit diagram of a comparator used in the circuit of Figure 3.

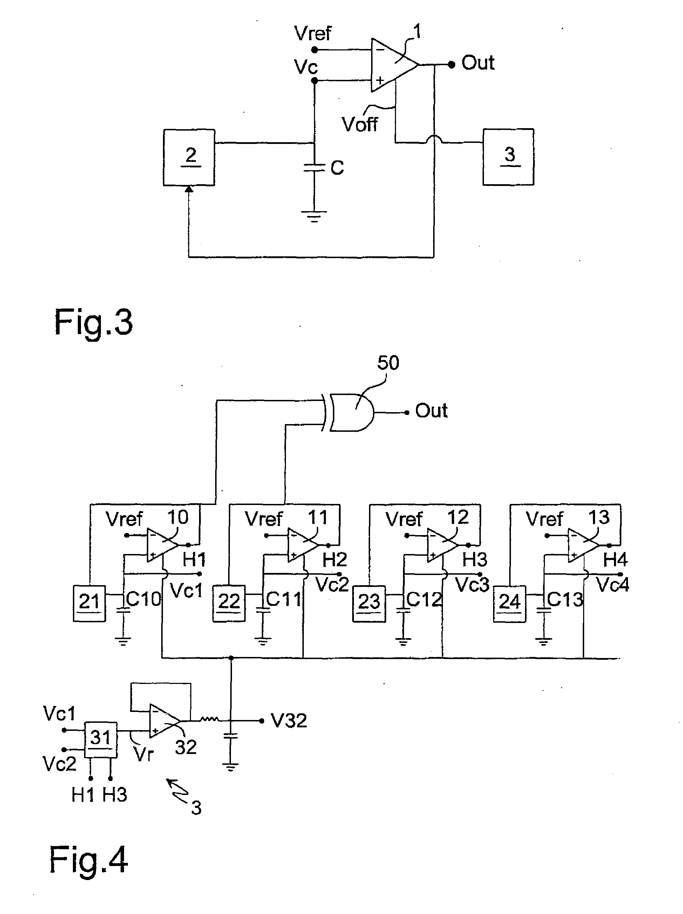

With reference to Figure 3 a circuit block diagram of an oscillator is shown according to the present invention. The oscillator comprises at least one capacitor C, at least one comparator 1 and at least one device 2 suitable for charging or discharging the capacitor C. The capacitor C has a terminal connected to ground and a terminal connected to the non-inverting terminal of the comparator 1 while on the inverting terminal there is a reference voltage Vref. The comparator 1 is suitable for comparing the voltage Vc on the capacitor C with the reference voltage and is suitable for activating the device 2 for commanding the charging or discharging of the capacitor. More precisely when the voltage Vc equals the voltage Vref the comparator 1 commands the discharging of the capacitor C while when the voltage Vc tends to zero the comparator commands the charging of the capacitor C.

The oscillator comprises means 3 for the application of a preset voltage value Voff in input to the comparator 1 when the comparator itself commands the charging of the capacitor C. The comparator therefore compares a voltage given by the reference voltage Vref diminished by the preset voltage value Voff with the voltage on the capacitor Vc or the voltage on the capacitor Vc added to the preset voltage value Voff with the reference voltage Vref; in particular the voltage value Voff is proportional to the period of time Δt which the comparator 1 used for switching. In this way the comparator anticipates the switching of the period of time Δt.

Said means 3 are coupled to the capacitor C so as to automatically generate the voltage value Voff; the means 3 take the final value of the voltage on the capacitor C and determine the voltage value Voff on the basis of this value.

The oscillator according to the invention presents a four-phase structure and produces a square-wave signal in output, as shown in Figure 4. The oscillator comprises four capacitors C10-C13, four respective comparators 10-13 and four respective devices 21-24 suitable for charging or discharging the respective capacitors C10-C13. The capacitors C10-C13 have a terminal connected to ground and the other respective terminals connected to the respective non-inverting terminals of the comparators 10-13 while on the inverting terminal of the same the comparators there is a reference voltage Vref. The comparators 10-13 are each suitable for comparing the voltages Vc1-Vc4 on the capacitors C10-C13 with the reference voltage Vref and are suitable for activating, by means of the output signals H1-H4, the devices 21-24 for commanding the charging or the discharging of the capacitors C10-C13. More precisely when one of the voltages Vcl-Vc4 equals the voltage Vref the respective of the comparators 10-13 commands the discharging of the respective of the capacitors C10-C13 while when one of the voltages Vc1-Vc4 tends to zero the respective of the comparators 21-24 commands the charging of the respective of the capacitors C10-C13. The output Out of the oscillator is the output signal of an exclusive gate OR 50 having the signals H1 and H2 in input.

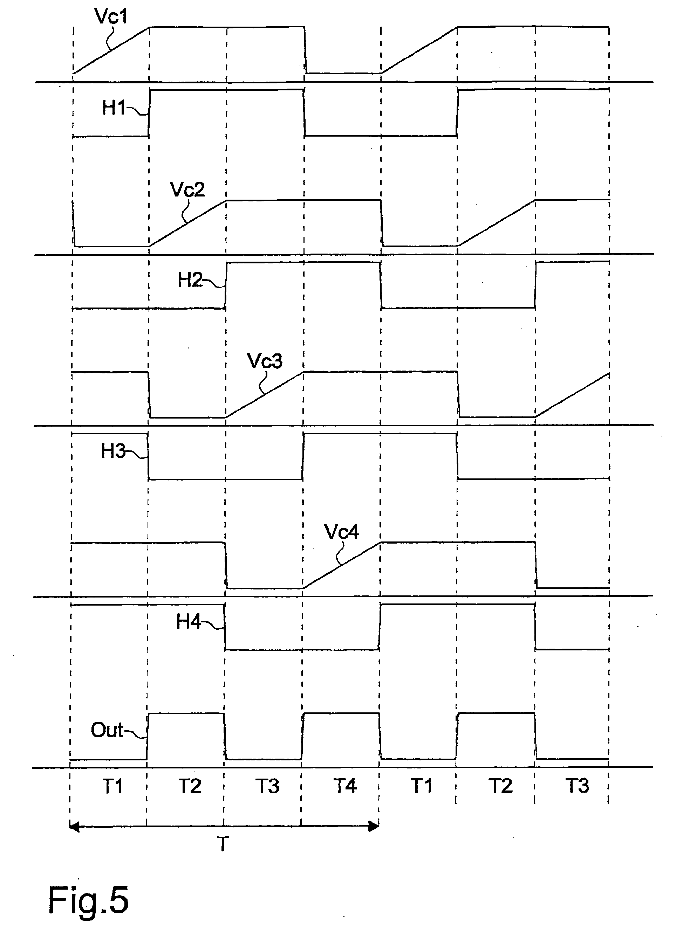

In the oscillator of Figure 4 the devices 21-24 are commanded to charge for the respective capacitors C10-C13 in four distinct phases for each cycle. That is each complete oscillation cycle T comprises four successive periods of time T1-T4, preferably equal to each other, to which the respective charging phase of the capacitors C10-C13 corresponds, as shown in Figure 5. As can be seen, again in the graph of Figure 5, each of the voltages Vc1-Vc4 keeps the maximum value for two periods of time subsequent to the period of time of the charge; for example the voltage Vc1 reaches the maximum value at the end of the period of time T1 and keeps said maximum value for the successive periods of time T2 and T3 while in the period of time T4 zero is reached rapidly for the phase of discharging the associated capacitor C10. Each of the voltages Vc2-Vc4 has a time path similar to the voltage Vc1.

The charge of the capacitors comes about sequentially, that is the charging of each capacitor comes about when the previous capacitor in the sequence of the capacitors has completed its charging; in the apparatus of Figure 4 the charging of the capacitor C10 comes about when the capacitor C13 has completed its charging, the charging of the capacitor C11 comes about when the capacitor C10 has completed its charging and so on.

The discharging of each capacitor comes about after two successive of the periods of time T1-T4 starting from when said capacitor has reached its maximum value. In Figure 5 the signals H1-H4 can also be seen in output from the comparators 10-13; said signals remain at the maximum value for two periods of time of the periods of time T1-T4 that are successive to the period of time of the charging of the respective capacitor C10-C13.

In Figure 5 the square wave signal can also be seen in output from the oscillator Out whose frequency is equal to the inverse of the semiperiod T/2; in turn the semiperiod of the oscillating frequency is equal to the product given from the value of the capacitor by the voltage Vref divided by the current that circulates in the same capacitor.

In the oscillator of Figure 4 the means 3 process the offset voltage Voff starting from the voltages Vc1 or Vc3 in input. The means 3 comprise a multiplexer 31 suitable for selecting the voltage Vc1 or the voltage Vc3 when they are at the maximum value, an operational amplifier 32 with the output connected to the inverting terminal and the series of a resistor and a capacitor connected with the output of the amplifier 32 and ground. The multiplexer 31 has also preferably in input the signals H1 and H3 and its output is connected with the non-inverting terminal of the amplifier 32. The multiplexer 31 works so that when the signal H1 is high in output, the signal Vc1 will be present while when the signal H3 is high in output the signal Vc3 will be present. In this way the voltage Vr present on the non-inverting terminal of the amplifier 32 is given by the reference voltage Vref added to the voltage Voff proportional to the time of delay Δt. Therefore we will have the voltage V32 on the output terminal of the operational amplifier 32 that is given by V32=K*(Vref+Voff) where K is the gain of the follower structure made up of the amplifier 32 with the inverting terminal connected to the output and the filter made up of the resistor and by the capacitor, normally the gain is K=1. The voltage V32 is used by the comparators 10-13 to generate an offset of voltage on the non-inverting terminal equal to the difference between the voltage V32 and the voltage applied at the inverting terminal Vref. In a real comparator the switching comes about with a delay Δt, therefore, considering one of the comparators 10-13, one real comparator 10-13 can be considered like an ideal comparator, that is with nil switching time, if at its inverting terminal we consider the application of a voltage given by Vref+Voff. If at the non-inverting terminal the voltage on the capacitor is added to the voltage V32-Vref we will have the switching of the comparator 10, for example, coming about when Vc1+(V32-Vref)=Vref+Voff that is when Vcl=Vref; therefore there will be the annulment of the switching time of the comparator 10. The effect is to have diminished the voltage Vref applied at the inverting terminal of a real comparator by a preset value Voff, proportional to the switching time Δt, so as to anticipate the switching of the same comparator so that the switching comes about when Vref=Vcl eliminating the delay of the real comparator 10.

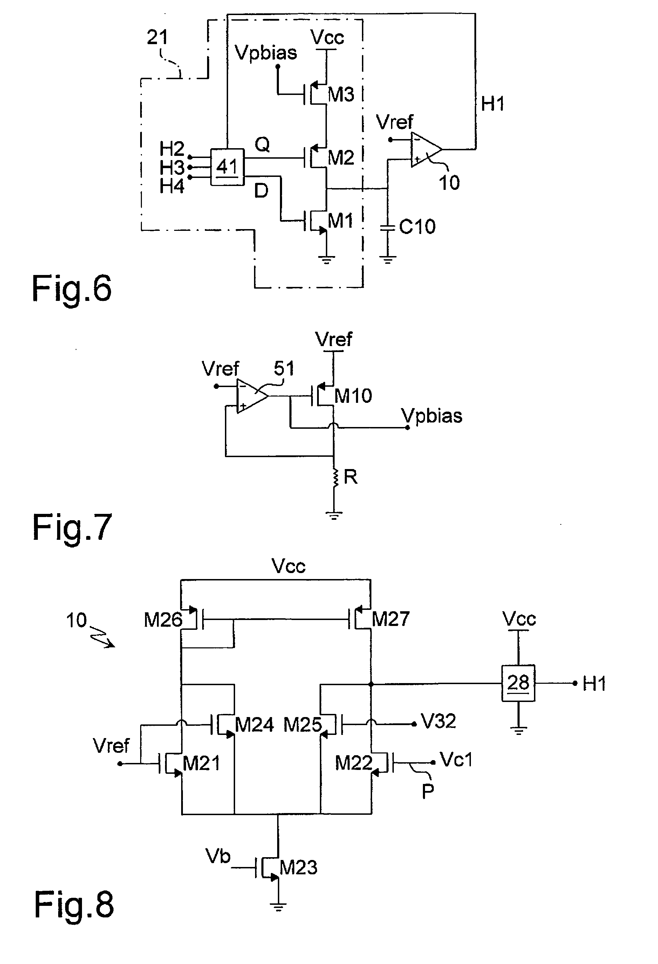

In Figure 6 one of the devices 21-24 is shown more in detail; in particular means 21 suitable for charging or discharging the capacitor C10 is shown. The device 21 comprises a logic circuitry 41 having in input the outputs H1-H4 of all the comparators 10-13 and suitable for supplying two signals in output Q and D to determine the charging and the discharging of the capacitor according to whether the value of the signal H1 is low or high. The device 21 also comprises an NMOS transistor M1 and a PMOS transistor M2 driven respectively by the signals Q and D produced by the logic circuitry 41 while a PMOS transistor M3 has the gate terminal connected to a bias voltage Vpbias and has the drain terminal connected to the drain terminal of the transistor M2 and the source terminal connected to the voltage Vcc. For discharging the capacitor C10 the signal D is such that it turns on the transistor M1 while the signal Q turns off the transistor M2. During the charging phase the signal Q is such that it turns on the transistor M2 to enable the charging at the voltage Vcc and the signal D is such that it turns off the transistor M1.

In Figure 7 a circuit capable of generating the bias voltage Vpbias is shown; said circuit comprises an operational amplifier 51 having the non-inverting input terminal connected to the voltage Vref while the inverting terminal is connected to the drain of a PMOS transistor M10 and to a resistor R having the other terminal connected to ground. The gate terminal of the transistor M10 is connected with the output of the amplifier 51 while the source terminal is connected with the voltage Vref; the output of the amplifier 51 supplies the voltage Vpbias.

In Figure 8 a possible circuit implementation of one of the comparators 10-13 is shown, in particular of the comparator 10. Said comparator 10 comprises a differential stage M21-M22 closed by a current mirror M26, M27. The NMOS transistors M21, M22 have the source terminal in common connected to the drain terminal of the NMOS transistor M23 having the gate terminal connected to the voltage Vb. The gate terminal of the transistor M21 is connected to the voltage Vref while the gate terminal of the transistor M22 is connected to the voltage Vc1. A transistor M24 having the terminals connected like the transistor M21, permits a double value current on the drain terminal in common while a transistor M25 having the source and drain terminals connected with the source and drain terminals of the transistor M22 has the gate terminal connected to the voltage V32; in this way on the node P there will be an offset voltage given by the voltage V32-Vref. The voltage present on the drain terminal of the transistors M22, M25 and M27 is inverted by the circuit block 28 to have the voltage signal H1 in output.

Another method for obtaining the means 3 is constituted by the use of two operational amplifiers with the inverting input connected to the output and having the non-inverting input connected to the voltage Vc1 and to the voltage Vc3 and being enabled by means of the two signals H1 and H3. There will be the alternated operation of one or of the other amplifier during the operation of the oscillator.

The application of a voltage Voff to the comparators 10-13 permits the dynamic adjustment, according to the working conditions and the process variables, the anticipation of the switching of the comparators to adjust the delay to the response.

From simulations carried out between the oscillators of Figure 1 and of Figure 4 using a supply voltage Vcc=1.2 V and a reference voltage Vrefl=Vref=0.6 V we obtain the period of time Δt of 2ns for the oscillator of Figure 2 and 0.5ns for the oscillator of Figure 4. In addition we obtain a variation of voltage ΔV of 216mV for the oscillator of Figure 1 and 45mV for the oscillator of Figure 4.

## Claims

1. An oscillator system comprising four oscillators, each of said oscillators is configured to generate an oscillating signal (H1, H2, H3, H4) and comprises a capacitor (C10, C11, C12, C13), its associated comparator (10, 11, 12, 13) and its associated device (21, 22, 23, 24) suitable for charging or discharging said capacitor (C10, C11, C12, C13), said capacitor being coupled with said comparator (10, 11, 12, 13), said comparator being suitable for comparing the voltage on said capacitor (C10, C11, C12, C13) with a reference voltage (Vref) and being suitable for activating said device (21, 22, 23, 24) for controlling the charging or the discharging of said capacitor (C10, C11, C12, C13), said oscillator comprising means (3) for applying a preset voltage value (Voff) in input to said comparator (10, 11, 12, 13) when said device (21, 22, 23, 24) controls the charging of said capacitor (C10, C11, C12, C13), said comparator (10, 11, 12, 13) being suitable for comparing said reference voltage (Vref) diminished by said preset voltage (Voff) with said voltage on the capacitor or said voltage on the capacitor added to said preset voltage (Voff) with said reference voltage (Vref), said preset voltage (Voff) being proportional to the period of time (Δt) that said comparator (10, 11, 12, 13) takes for switching, wherein said devices (21-24) are adapted to:
- charge their respective associated capacitors (C10-C13) in sequence one after the other in four distinct periods of time (T1-T4) corresponding to charging times of the respective capacitors (C10-C13), and whose sum forms the period (T) of said oscillating signal; and
- abruptly discharge each capacitor after two of said distinct periods of time subsequent to the period of time of the charge of said capacitor.

2. Oscillator according to claim 1, **characterised in that** each device (21-24) is suitable for keeping the voltage at the terminals of the respective capacitor (C10-C13) at the maximum value for two successive periods of said four periods of time (T1-T4), said two periods of time being successive to the period of time taken for charging said capacitor.

3. Oscillator according to claim 2, **characterised in that** said means (3) are suitable for generating said preset voltage (Voff) on the basis of the voltages (Vc1, Vc3) at the terminals of the first (C10) and of the third (C12) capacitor of the sequence of the four capacitors (C10-C13).

4. Operation method of an oscillator system comprising four oscillators, each of said oscillators is configured to generate an oscillating signal (H1, H2, H3, H4) and comprises a capacitor (C10, C11, C12, C13), its associated comparator (10, 11, 12, 13) and its associated device (21, 22, 23, 24) suitable for charging or discharging said capacitor (C10, C11, C12, C13), said method comprising a first step of applying a reference voltage (Vref) to said comparator (10, 11, 12, 13), a second step for comparing the voltage on said capacitor (C10, C11, C12, C13) with said reference voltage (Vref), a third step for controlling the charging of said capacitor (C10, C11, C12, C13), a step for applying a preset voltage value (Voff) to said comparator (10, 11, 12, 13) before the second step so that in said second step the comparison comes about between said reference voltage (Vref) diminished by said preset voltage value (Voff) and said voltage on the capacitor or between said voltage on the capacitor added to said preset voltage (Voff) with said reference voltage (ref), a step for determining said preset voltage value (Voff) proportional to the period of time (Δt) that said comparator (10, 11, 12, 13) takes for switching, wherein the third step comprises charging the respective capacitors (C10-C13) in sequence one after the other in four distinct periods of time (T1-T4) corresponding to charging times of the respective capacitors (C10-C13), and whose sum forms the period (T) of said oscillating signal, and abruptly discharging each capacitor after two of said distinct periods of time subsequent to the period of time of the charge of said capacitor.

## Patentansprüche

1. Oszillatorsystem aufweisend vier Oszillatoren, wobei jeder von den Oszillatoren konfiguriert ist, ein Oszillationssignal (H1, H2, H3, H4) zu erzeugen, und eine Kapazität (C10, C11, C12, C13), seinen zugeordneten Komparator (10, 11, 12, 13) und seine zugeordnete Einrichtung (21, 22, 23, 24), die zum Laden oder Entladen der Kapazität (C10, C11, C12, C13) geeignet ist, aufweist, wobei die Kapazität mit dem Komparator (10, 11, 12, 13) gekoppelt ist, wobei der Komparator zum Vergleichen der Spannung an der Kapazität (C10, C11, C12, C13) mit einer Referenzspannung (Vref) geeignet ist und zum Aktivieren der Einrichtung (21, 22, 23, 24) zum Steuern des Ladens und des Entladens der Kapazität (C10, C11, C12, C13) geeignet ist, wobei der Oszillator Mittel (3) zum Anlegen eines voreingestellten Spannungswerts (Voff) als Eingabe für den Komparator (10, 11, 12, 13) aufweist, wenn die Einrichtung (21, 22, 23, 24) das Laden der Kapazität (C10, C11, C12, C13) steuert, wobei der Komparator (10, 11, 12, 13) zum Vergleichen der Referenzspannung (Vref) vermindert um die voreingestellte Spannung (Voff) mit der Spannung an der Kapazität oder der Spannung an der Kapazität addiert zu der voreingestellten Spannung (Voff) mit der Referenzspannung (Vref) geeignet ist, wobei die voreingestellte Spannung (Voff) proportional zu der Zeitperiode (Δt) ist, die der Komparator (10, 11, 12, 13) zum Schalten benötigt, wobei die Einrichtungen (21-24) angepasst sind:
- ihre jeweils zugeordnete Kapazitäten (C10-C13) in Reihe nacheinander in vier verschiedenen Zeitperioden (T1-T4), die den Ladezeiten der jeweiligen Kapazitäten (C10-C13) entsprechen und deren Summe die Periode (T) des Oszillationssignals bildet, zu laden; und
- jede Kapazität nach zwei dieser verschiedenen Zeitperioden im Anschluss an die Zeitperiode der Ladung der Kapazität schlagartig zu entladen.

2. Oszillator gemäß Anspruch 1, **dadurch gekennzeichnet, dass** jede Einrichtung (21-24) zum Halten der Spannung an den Anschlüssen der jeweiligen Kapazität (C10-C13) bei dem Maximalwert für zwei aufeinanderfolgende Perioden der vier Zeitperioden (T1-T4) geeignet ist, wobei diese zwei Zeitperioden der Zeitperiode nachfolgen, die zum Laden der Kapazität belegt wurde.

3. Oszillator gemäß Anspruch 2, **dadurch gekennzeichnet, dass** die Mittel (3) zum Erzeugen der voreingestellten Spannung (Voff) basierend auf der Spannung (Vc1, Vc3) an den Anschlüssen der ersten (C10) und der dritten (C12) Kapazität der Reihe der vier Kapazitäten (C10-C13) geeignet sind.

4. Betriebsverfahren für ein Oszillatorsystem mit vier Oszillatoren, wobei jeder der Oszillatoren konfiguriert ist, ein Oszillationssignal (H1, H2, H3, H4) zu erzeugen, und eine Kapazität (C10, C11, C12, C13), seinen zugeordneten Komparator (10, 11, 12, 13) und seine zugeordnete Einrichtung (21, 22, 23, 24), die zum Laden oder Entladen der Kapazität (C10, C11, C12, C13) geeignet ist, aufweist, wobei das Verfahren aufweist einen ersten Schritt mit Anlegen einer Referenzspannung (Vref) an den Komparatoren (10, 11, 12, 13), einen zweiten Schritt zum Vergleichen der Spannung an der Kapazität (C10, C11, C12, C13) mit der Referenzspannung (Vref), einen dritten Schritt zum Steuern des Ladens der Kapazität (C10, C11, C12, C13), einen Schritt zum Anlegen eines voreingestellten Spannungswerts (Voff) an den Komparator (10, 11, 12, 13) vor dem zweiten Schritt, so dass in dem zweiten Schritt der Vergleich zwischen der Referenzspannung (Vref) vermindert um den voreingestellten Spannunsgwert (Voff) und der Spannung an der Kapazität oder zwischen der Spannung an der Kapazität addiert zu der voreingestellten Spannung (Voff) mit der Referenzspannung (Vref) zustande kommt, einen Schritt zum Bestimmen des voreingestellten Spannungswerts (Voff) proportional zu der Zeitperiode (Δt), die der Komparator (10, 11, 12, 13) zum Schalten benötigt, wobei der dritte Schritt Laden der jeweiligen Kapazitäten (C10-C13) in Reihe eine nach der anderen in vier unterschiedlichen Zeitperioden (T1-T4), die Ladezeiten der jeweiligen Kapazitäten (C10-C13) entsprechen und deren Summe die Periode (T) des Oszillationssignals bildet, und ein schlagartiges Entladen jeder Kapazität nach zwei der verschiedenen Zeitperioden im Anschluss an die Zeitperiode des Ladens der Kapazität aufweist.

## Revendications

1. Système oscillateur comprenant quatre oscillateurs, chacun desdits oscillateurs étant configuré pour générer un signal oscillant (H1, H2, H3, H4) et comprenant un condensateur (C10, C11, C12, C13), son comparateur associé (10, 11, 12, 13) et son dispositif associé (21, 22, 23, 24) approprié pour charger ou décharger ledit condensateur (C10, C11, C12, C13), ledit condensateur étant couplé audit comparateur (10, 11, 12, 13), ledit comparateur étant approprié pour comparer la tension sur ledit condensateur (C10, C11, C12, C13) à une tension de référence (Vref) et étant approprié pour activer ledit dispositif (21, 22, 23, 24) pour commander la charge ou la décharge dudit condensateur (C10, C11, C12, C13), ledit oscillateur comprenant des moyens (3) pour appliquer une valeur de tension préréglée (Voff) en entrée audit comparateur (10, 11, 12, 13) lorsque ledit dispositif (21, 22, 23, 24) commande la charge dudit condensateur (C10, C11, C12, C13), ledit comparateur (10, 11, 12, 13) étant approprié pour comparer ladite tension de référence (Vref) diminuée de ladite tension préréglée (Voff) à ladite tension sur le condensateur ou ladite tension sur le condensateur additionnée à ladite tension préréglée (Voff) à ladite tension de référence (Vref), ladite tension préréglée (Voff) étant proportionnelle à la période de temps (Δt) que prend la commutation dudit comparateur (10, 11, 12, 13), dans lequel lesdits dispositifs (21-24) sont conçus pour :
- charger leurs condensateurs associés respectifs (C10-C13) successivement l'un après l'autre dans quatre périodes de temps distinctes (T1-T4), correspondant à des temps de charge des condensateurs respectifs (C10-C13) et dont la somme forme la période (T) dudit signal oscillant ; et
- décharger brusquement chaque condensateur deux desdites périodes de temps distinctes après la période de temps de charge dudit condensateur,

2. Oscillateur selon la revendication 1, **caractérisé en ce que** chaque dispositif (21-24) est approprié pour maintenir la tension aux bornes du condensateur respectif (C10-C13) à la valeur maximale pendant deux périodes successives desdites quatre périodes de temps (T1-T4), lesdites deux périodes de temps étant successives à la période de temps prise pour la charge dudit condensateur.

3. Oscillateur selon la revendication 2, **caractérisé en ce que** lesdits moyens (3) sont appropriés pour générer ladite tension préréglée (Voff) sur la base des tensions (Vc1, Vc3) aux bornes du premier (C10) et du troisième (C12) condensateur de la succession des quatre condensateurs (C10-C13).

4. Procédé de fonctionnement d'un système oscillateur comprenant quatre oscillateurs, chacun desdits oscillateurs étant configuré pour générer un signal oscillant (H1, H2, H3, H4) et comprenant un condensateur (C10, C11, C12, C13), son comparateur associé (10, 11, 12, 13) et son dispositif associé (21, 22, 23, 24) approprié pour charger ou décharger ledit condensateur (C10, C11, C12, C13), ledit procédé comprenant une première étape consistant à appliquer une tension de référence (Vref) audit comparateur (10, 11, 12, 13), une deuxième étape consistant à comparer la tension sur ledit condensateur (C10, C11, C12, C13) à ladite tension de référence (Vref), une troisième étape consistant commander la charge dudit condensateur (C10, C11, C12, C13), une étape consistant appliquer une valeur de tension préréglée (Voff) audit comparateur (10, 11, 12, 13) avant ladite deuxième étape de manière à ce que, à ladite deuxième étape, la comparaison s'effectue entre ladite tension de référence (Vref) diminuée de ladite valeur de tension préréglée (Voff) et ladite tension sur le condensateur ou entre ladite tension sur le condensateur additionnée à ladite tension préréglée (Voff) et ladite tension de référence (Vref), une étape consistant à déterminer ladite valeur de tension préréglée (Voff) proportionnelle à la période de temps (Δt) que prend la commutation dudit comparateur (10, 11, 12, 13), dans lequel la troisième étape consiste à charger les condensateurs respectifs (C10-C13) successivement l'un après l'autre dans quatre périodes de temps distinctes (T1-T4), correspondant à des temps de charge des condensateurs respectifs (C10-C13) et dont la somme forme la période (T) dudit signal oscillant, et décharger brusquement chaque condensateur deux desdites périodes de temps distinctes après la période de temps de charge dudit condensateur.
